# EUROPÄISCHE PATENTSCHRIFT

(11) **EP 2 319 961 B1**
(45) Veröffentlichungstag und Bekanntmachung des Hinweises auf die Patenterteilung: **16.04.2014**
(21) Anmeldenummer: 10188589.5
(22) Anmeldetag: 22.10.2010
(51) Int. Cl.: C30B 29/06, C30B 13/20

(54) **Vorrichtung zur Herstellung eines Einkristalls aus Silizium durch Umschmelzen von Granulat**
Device for producing a single crystal composed of silicon by remelting granules
Dispositif destiné à la fabrication d'un monocristal en silicium par refonte de granulés

(30) Priorität: 28.10.2009 DE 102009051010
(43) Veröffentlichungstag der Anmeldung: 11.05.2011
(73) Patentinhaber: Siltronic AG, 81737 München (DE)
(72) Erfinder: von Ammon, Wilfried, 5122, Hochburg (AT); Altmannshofer, Ludwig, 84323, Massing (DE); Muiznieks, Andris, 1058, Riga (LV)
(74) Vertreter: Staudacher, Wolfgang

(56) Entgegenhaltungen:
- DE-A1- 10 204 178
- DE-A1-102008 013 326

## Beschreibung

Gegenstand der Erfindung ist eine Vorrichtung zur Herstellung eines Einkristalls aus Silizium durch Umschmelzen von Granulat. Die Vorrichtung umfasst eine sich drehende Platte aus Silizium mit einer zentralen Öffnung und mit einer, die Öffnung umschließenden und sich unter die Platte erstreckenden, rohrförmigen Erweiterung aus Silizium, weiterhin eine erste, über der Platte angeordnete Induktionsheizspule zum Schmelzen von Granulat und schließlich eine zweite, unter der Platte angeordnete Induktionsheizspule zum Kristallisieren des geschmolzenen Granulats.

In der DE 10 2008 013 326 A1 ist eine Vorrichtung beschrieben, die die genannten Merkmale aufweist.
Die Herstellung eines Einkristalls mit einer derartigen Vorrichtung ist dem Zonenziehen, FZ-Verfahren ("floating zone method"), ähnlich. Der besondere Unterschied besteht darin, dass an Stelle eines polykristallinen Vorratsstabes ("feed rod") aus Silizium im Wesentlichen polykristallines Granulat aus Silizium umgeschmolzen wird. Das Granulat kann durch Abscheiden in der Wirbelschicht erhalten werden. Zum Schmelzen des Granulats und zum Kristallisieren des geschmolzenen Granulats werden jeweils eigene Induktionsheizspulen ("inductor coils") eingesetzt, die sich über, beziehungsweise unter einer sich drehenden Platte aus Silizium befinden. Zur Platte aus Silizium zugeführtes Granulat wird dort induktiv geschmolzen und fließt als Film aus flüssigem Silizium durch die zentrale Öffnung der Platte an der rohrförmigen Erweiterung aus Silizium entlang zu einer Schmelze, die sich auf der Stirnseite des wachsenden Einkristalls aus Silizium bildet.

Am Anfang des Verfahrens wird die rohrförmige Erweiterung, die zu diesem Zeitpunkt an ihrem unteren Rand noch durch eine Schicht aus festem Silizium verschlossen ist, mit Hilfe der, unter der Platte angeordneten Induktionsheizspule angeschmol-zen, wobei ein kleines Volumen an flüssigem Silizium entsteht. Der untere Rand der rohrförmigen Erweiterung wird auf einen möglichst kurzen Abstand zum Rand des Innenlochs der Induktionsheizspule gebracht, damit eine hohe Energiedichte auf die rohrförmige Erweiterung und das sich bildende Volumen von geschmolzenem Silizium induktiv übertragen werden kann. Dazu wird die unter der Platte angeordnete Induktionsheizspule lateral verschoben. Anschließend wird ein einkristalliner Impfkristall an das Volumen von geschmolzenem Silizium angesetzt und, entsprechend der FZ-Methode, zunächst ein Dünnhals ("neck"), dann ein, bis zu einem Enddurchmesser konusförmig erweiterter Abschnitt des Einkristalls und schließlich ein Abschnitt mit konstantem Soll-Durchmesser kristallisiert. Das dafür notwendige Material an geschmolzenem Silizium wird durch teilweises Schmelzen der rohrförmigen Erweiterung, durch Schmelzen der sie verschließenden Schicht, durch teilweises Schmelzen der oberen Seite der Platte und später durch Schmelzen von Granulat aus Silizium bereitgestellt. Es bildet sich eine Schmelze aus, die sich durch das Innenloch der, unter der Platte angeordneten Induktionsheizspule erstreckt. Wenn der Abschnitt mit dem konstanten Soll-Durchmesser kristallisiert wird oder gegebenenfalls auch schon zuvor, werden die Induktionsheizspule und die Schmelze so relativ zu einander positioniert, dass sich die Schmelze im Wesentlichen symmetrisch durch das Innenloch der Induktionsheizspule erstreckt.

In der DE 102 04 178 A1 sind das Verfahren und Vorrichtungen beschrieben, die zur Durchführung des Verfahrens geeignet sind. Einige dieser Vorrichtungen umfassen eine mit Wasser gekühlte Abschirmplatte aus Metall, die zwischen der Platte aus Silizium und der zweiten Induktionsheizspule angeordnet ist. Sie dient dem Zweck, die Platte aus Silizium vom elektromagnetischen Feld der zweiten Induktionsheizspule abzuschirmen und als Wärmesenke, um Wärme von der Platte aus Silizium abzuführen.

Im Betrieb wird die Abschirmplatte thermisch stark belastet, mit der Folge, dass sie dazu neigt, sich zu wölben. Reagiert man darauf, indem man die Abschirmplatte dicker ausführt, um ein sich Wölben zu vermeiden, oder indem man axial genügend Raum lässt, damit sich die Abschirmplatte wölben kann, ohne die zweite Induktionsheizspule oder die Platte aus Silizium zu berühren, besteht die Gefahr, dass die Schmelze am Ende der rohrförmigen Erweiterung festfriert und der Film an nachfließendem Silizium unterbrochen wird.

Aufgabe der vorliegenden Erfindung ist es, diese Gefahr ohne nachteilige Folgen zu beseitigen.

Gelöst wird die Aufgabe durch eine Vorrichtung zur Herstellung eines Einkristalls aus Silizium durch Umschmelzen von Granulat, umfassend
eine sich drehende Platte aus Silizium mit einer zentralen Öffnung und mit einer, die Öffnung umschließenden und sich unter die Platte erstreckenden, rohrförmigen Erweiterung aus Silizium;
eine erste, über der Platte angeordnete Induktionsheizspule zum Schmelzen von Granulat; und
eine zweite, unter der Platte angeordnete Induktionsheizspule zum Kristallisieren des geschmolzenen Granulats, wobei die zweite Induktionsheizspule auf ihrer, der Platte aus Silizium gegenüberliegenden Seite eine untere Schicht aus einem magnetisch leitenden Werkstoff und eine obere Schicht aufweist, in der mindestens ein Kühlkanal zum Durchleiten eines Kühlmittels vorhanden ist.

Die sich drehende Platte hat eine zentrale Öffnung und eine, die Öffnung umschließende und sich unter die Platte erstreckende, rohrförmige Erweiterung aus Silizium. Die zweite Induktionsheizspule weist auf ihrer, der Platte aus Silizium gegenüberliegenden Seite eine untere Schicht aus einem magnetisch leitenden Werkstoff und eine obere Schicht auf, in der mindestens ein Kühlkanal zum Durchleiten eines Kühlmittels vorhanden ist. Die zweite Induktionsheizspule ist vorzugsweise aus Silber oder aus Kupfer gefertigt. Die untere Schicht steht in direktem, thermischen Kontakt mit der zweiten Induktionsheizspule, die obere Schicht in direktem, thermischen Kontakt mit der unteren Schicht. Die obere Schicht und die zweite Induktionsheizspule sind galvanisch voneinander getrennt. In den um das Innenloch der zweiten Induktionsheizspule liegenden Rand der oberen Schicht können Schlitze eingearbeitet sein, um entgegenzuwirken, dass die zweite Induktionsheizspule in diesen Bereich der oberen Schicht induktiv einkoppelt. Ein durch den Kühlkanal der oberen Schicht strömendes Kühlmittel, beispielsweise Wasser, kühlt die, der zweiten Induktionsheizspule gegenüberliegende, untere Seite der sich drehenden Platte. Als ein, die obere Schicht bildender Werkstoff kommt vorzugsweise ein Wärme gut leitender Werkstoff, beispielsweise ein Metall oder eine Keramik, in Betracht. Besonders bevorzugt ist ein metallischer Werkstoff, der Wärme gut leitet und die elektrischen Eigenschaften von Silizium als Halbleitermaterial nicht beeinträchtigt. Silber und Kupfer sind besonders geeignet. Die obere Schicht sollte möglichst wenig Wärme zur gegenüberliegenden Platte abstrahlen. Es ist daher bevorzugt, die obere Schicht auf der, der Platte gegenüberliegenden Seite zu schwärzen.

Ein weiteres, bevorzugtes Merkmal der oberen Schicht ist eine Ausnehmung im Bereich des Innenlochs der Induktionsheizspule, beispielsweise eine V-förmige oder elliptische Ausnehmung, die vorzugsweise gegenüber der Stromzuführung der Induktionsheizspule angeordnet ist. Die Ausnehmung ermöglicht einen kurzen Abstand und damit eine effektive induktive Kopplung zwischen der Induktionsheizspule und der rohrförmigen Erweiterung der Platte. Dadurch wird es einfacher, das kleine Volumen von geschmolzenem Silizium zu bilden, an das der Impfkristall am Anfang des Herstellungsverfahrens angesetzt wird. Wenn die Ausnehmung vorhanden ist, kühlt die obere Schicht die rohrförmige Erweiterung der Platte und den daran angrenzenden Bereich der Platte weniger effektiv. Um diesen Nachteil auszugleichen, ist in der zweiten Induktionsheizspule mindestens eine Düse vorhanden, durch die ein Gas zum Kühlen der rohrförmigen Erweiterung und eines daran angrenzenden Bereichs der Platte geleitet werden kann. Was die untere Schicht betrifft, so kommt als magnetisch leitender Werkstoff vorzugsweise ein ferromagnetischer Kunststoff, beispielsweise ein Weicheisenteilchen enthaltender, thermoplastischer Kunststoff in Betracht. In der US 4,486,641 ist beschrieben, dass solche Werkstoffe als Beschichtung von Induktionsheizspulen eingesetzt werden können, um die Richtung und Intensität des magnetischen Flusses zu steuern. Die untere Schicht konzentriert das von der zweiten Induktionsheizspule erzeugte Magnetfeld auf die nahe Umgebung der Induktionsheizspule, insbesondere auf den Bereich der Schmelze, der dem Innenloch der Induktionsheizspule am nächsten ist.

Die Erfindung wird nachfolgend an Hand von Figuren näher beschrieben.
Fig.1 zeigt eine besonders bevorzugte Ausführungsform der Vorrichtung im Querschnitt in einer Phase, in der ein kleines Volumen von flüssigem Silizium am unteren Rand der rohrförmigen Erweiterung der Platte gebildet wird.
Fig.2 zeigt die Vorrichtung gemäß Fig.1 in einer Phase, in der der Abschnitt des Einkristalls kristallisiert wird, der einen konstantem Soll-Durchmesser aufweist.

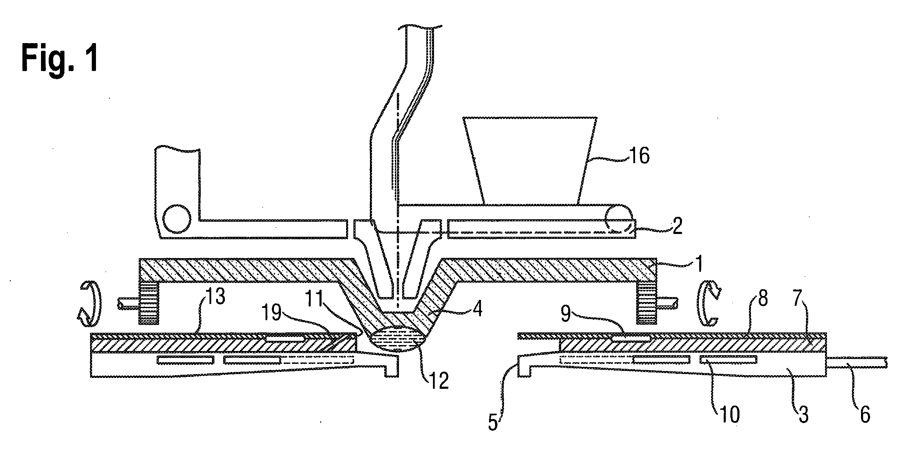

Die in Fig.1 gezeigte Vorrichtung umfasst eine sich drehende Platte 1 aus Silizium, eine über der Platte 1 angeordnete erste Induktionsheizspule 2 und eine unter der Platte angeordnete zweite Induktionsheizspule 3. Die sich drehende Platte 1 hat eine zentrale Öffnung und eine, die Öffnung umschließende und sich unter die Platte 1 erstreckende, rohrförmige Erweiterung 4 aus Silizium. Die erste Induktionsheizspule 2 hat vorzugsweise die Merkmale der in der DE 10 2008 013 326 A1 beschriebenen Induktionsheizspule. Die zweite Induktionsheizspule 3 ist als Flachspule mit einem zentralen Innenloch 5 ausgebildet. Sie wird von einer Seite über Stromzuführungen 6 mit elektrischem Strom versorgt. Die zweite Induktionsheizspule 3 ist auf der, der Platte 1 gegenüberliegenden Seite mit einer unteren Schicht 7 aus einem magnetisch leitenden Werkstoff beschichtet. Der magnetisch leitende Werkstoff besteht vorzugsweise aus einem, den magnetischen Fluss konzentrierenden Kunststoff, der unter dem Handelsnamen Fluxtrol^{®} angeboten wird. Auf der unteren Schicht befindet sich eine obere Schicht 8, in der mindestens ein Kühlkanal 9 zum Durchleiten eines Kühlmittels vorhanden ist und die vorzugsweise aus Silber oder aus Kupfer besteht. Es ist auch bevorzugt, dass die Induktionsheizspule 3 mindestens einen Kühlkanal 10 zum Durchleiten eines Kühlmittels aufweist.

Es ist weiterhin bevorzugt, dass die obere Schicht 8 an ihrem Rand im Bereich des Innenlochs 5 der Induktionsheizspule und auf der, den Stromzuführungen 6 gegenüberliegenden Seite, eine Ausnehmung 11 aufweist. Die Ausnehmung 11 erlaubt einen kurzen Abstand der Induktionsheizspule 3 zur rohrförmigen Erweiterung 4 in der Phase, in der ein kleines Volumen 12 von flüssigem Silizium am unteren Rand der rohrförmigen Erweiterung 4 der Platte 1 gebildet wird. Die Ausnehmung 11 ist beispielsweise V-förmig oder elliptisch ausgebildet.

In den, um das Innenloch 5 der zweiten Induktionsheizspule 3 liegenden Rand der oberen Schicht 8 können Schlitze eingearbeitet sein, um entgegenzuwirken, dass die zweite Induktionsheizspule in diesen Bereich der oberen Schicht induktiv einkoppelt.

Es ist ferner bevorzugt, dass die obere Schicht 8 auf der Seite 13, die der Platte 1 gegenüberliegt, geschwärzt ist.

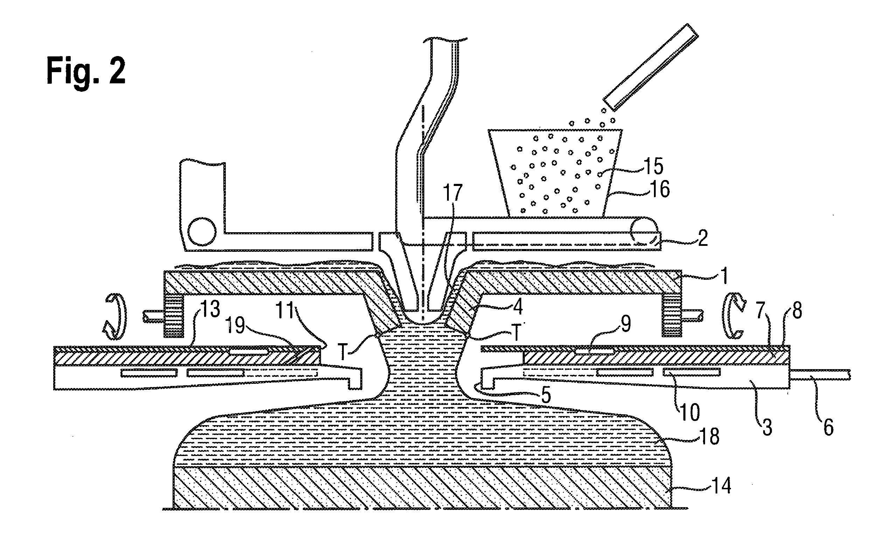

In Fig.2 ist die Phase dargestellt, in der der Abschnitt des Einkristalls 14 kristallisiert wird, der einen konstanten Soll-Durchmesser aufweist. In dieser Phase wird Granulat 15 durch einen Trichter 16 zur Platte 1 aus Silizium gefördert und mit Hilfe der ersten Induktionsheizspule 2 geschmolzen. Es fließt als Film 17 von geschmolzenem Silizium durch die rohrförmige Erweiterung 4 zu einer Schmelze 18, die auf dem wachsenden Einkristall 14 liegt und kontinuierlich kristallisiert wird. In dieser Phase werden die rohrförmige Erweiterung 4 und der daran angrenzende Bereich der Platte in der Umgebung der Aussparung 11 von der zweiten Induktionsheizspule 3 vergleichsweise stark erhitzt. Dadurch besteht die Gefahr, dass die rohrförmige Erweiterung 4 aus Silizium an ihrem unteren Ende übermäßig zu schmelzen beginnt und der Tripelpunkt T nach oben wandert, bis die Schmelze 18 überdehnt wird und der Kontakt zum unteren Ende der rohrförmigen Erweiterung 4 abreißt. Um dies zu vermeiden, ist es bevorzugt, die rohrförmige Erweiterung 4 aus Silizium und den daran angrenzenden Bereich der Platte 1 mit einem Gas, beispielsweise mit Argon, zu kühlen. Das Gas wird durch mindestens eine Düse 19 geleitet, die in der Induktionsheizspule angeordnet ist.

## Patentansprüche

1. Vorrichtung zur Herstellung eines Einkristalls aus Silizium durch Umschmelzen von Granulat, umfassend
eine sich drehende Platte (1) aus Silizium mit einer zentralen Öffnung und mit einer, die Öffnung umschließenden und sich unter die Platte erstreckenden, rohrförmigen Erweiterung (4) aus Silizium;
eine erste, über der Platte angeordnete Induktionsheizspule (2) zum Schmelzen von Granulat; und
eine zweite, unter der Platte angeordnete Induktionsheizspule (3) zum Kristallisieren des geschmolzenen Granulats, **dadurch gekennzeichnet, dass** die zweite Induktionsheizspule auf ihrer, der Platte aus Silizium gegenüberliegenden Seite eine untere Schicht (7) aus einem magnetisch leitenden Werkstoff und eine obere Schicht (8) aufweist, in der mindestens ein Kühlkanal (9) zum Durchleiten eines Kühlmittels vorhanden ist.

2. Vorrichtung nach Anspruch 1, wobei die untere Schicht (7) aus einem ferromagnetischen Kunststoff besteht.

3. Vorrichtung nach Anspruch 1 oder Anspruch 2, wobei die obere Schicht (8) aus einem metallischen Werkstoff besteht.

4. Vorrichtung nach einem der Ansprüche 1 bis 3, wobei die zweite Induktionsheizspule (3) und die obere Schicht (8) aus Silber oder Kupfer bestehen.

5. Vorrichtung nach einem der Ansprüche 1 bis 4, wobei die zweite Induktionsheizspule (3) mindestens einen Kühlkanal (10) zum Durchleiten eines Kühlmittels aufweist.

6. Vorrichtung nach einem der Ansprüche 1 bis 5, wobei die obere Schicht (8) an ihrem Rand im Bereich eines Innenlochs (5) der zweiten Induktionsheizspule (3) und auf der, Stromzuführungen (6) der zweiten Induktionsheizspule (3) gegenüberliegenden Seite eine Ausnehmung (11) aufweist, und die zweite Induktionsheizspule (3) mindestens eine Düse (19) zum Kühlen der rohrförmigen Erweiterung (4) und eines daran angrenzenden Bereichs der Platte (1) mit einem Gas.

7. Vorrichtung nach einem der Ansprüche 1 bis 6, wobei die obere Schicht (8) auf der, der Platte (1) gegenüberliegenden Seite geschwärzt ist.

## Claims

1. Device for producing a single crystal composed of silicon by remelting granules, comprising
a rotating plate (1) composed of silicon having a central opening and having a tubular extension (4) composed of silicon that encloses the opening and extends below the plate;
a first induction heating coil (2), arranged above the plate, for melting granules; and
a second induction heating coil (3), arranged below the plate, for crystallizing the molten granules, **characterized in that** the second induction heating coil has, on its side lying opposite the plate composed of silicon, a lower layer (7) composed of a magnetically permeable material and an upper layer (8), in which there is at least one cooling channel (9) for conducting a coolant.

2. Device according to Claim 1, wherein the lower layer (7) is composed of a ferromagnetic plastic.

3. Device according to Claim 1 or Claim 2, wherein the upper layer (8) is composed of a metallic material.

4. Device according to any of Claims 1 to 3, wherein the second induction heating coil (3) and the upper layer (8) are composed of silver or copper.

5. Device according to any of Claims 1 to 4, wherein the second induction heating coil (3) has at least one cooling channel (10) for conducting a coolant.

6. Device according to any of Claims 1 to 5, wherein the upper layer (8) has a cutout (11) at its edge in the region of an internal hole (5) in the second induction heating coil (3) and on the opposite side with respect to power supply lines (6) of the second induction heating coil (3), and the second induction heating coil (3) has at least one nozzle (19) for cooling the tubular extension (4) and an adjoining region of the plate (1) with a gas.

7. Device according to any of Claims 1 to 6, wherein the upper layer (8) is blackened on the side lying opposite the plate (1).

## Revendications

1. Dispositif pour la fabrication d'un monocristal de silicium par refonte d'un granulat, comprenant
une plaque rotative (1) en silicium comprenant une ouverture centrale et une extension tubulaire (4) en silicium fermant l'ouverture et s'étendant sous la plaque ;
une première bobine de chauffage par induction (2) agencée sur la plaque, pour la fusion du granulat ; et
une seconde bobine de chauffage par induction (3) agencée sous la plaque, pour la cristallisation du granulat fondu, **caractérisé en ce que** la seconde bobine de chauffage par induction comprend sur son côté opposé à la plaque en silicium une couche inférieure (7) en un matériau magnétiquement conducteur et une couche supérieure (8), dans laquelle au moins un canal de refroidissement (9) pour le passage d'un agent de refroidissement est prévu.

2. Dispositif selon la revendication 1, dans lequel la couche inférieure (7) est constituée par un plastique ferromagnétique.

3. Dispositif selon la revendication 1 ou la revendication 2, dans lequel la couche supérieure (8) est constituée par un matériau métallique.

4. Dispositif selon l'une quelconque des revendications 1 à 3, dans lequel la seconde bobine de chauffage par induction (3) et la couche supérieure (8) sont constituées par de l'argent ou du cuivre.

5. Dispositif selon l'une quelconque des revendications 1 à 4, dans lequel la seconde bobine de chauffage par induction (3) comprend au moins un canal de refroidissement (10) pour le passage d'un agent de refroidissement.

6. Dispositif selon l'une quelconque des revendications 1 à 5, dans lequel la couche supérieure (8) comprend une ouverture (11) sur son bord dans la zone d'un trou intérieur (5) de la seconde bobine de chauffage par induction (3) et sur le côté opposé à des entrées de courant (6) de la seconde bobine de chauffage par induction (3), et la seconde bobine de chauffage par induction (3) comprend au moins une buse (19) pour le refroidissement de l'extension tubulaire (4) et d'une zone adjacente à celle-ci de la plaque (1) avec un gaz.

7. Dispositif selon l'une quelconque des revendications 1 à 6, dans lequel la couche supérieure (8) est noircie sur le côté opposé à la plaque (1).
